**Europäisches Patentamt**

(19) **European Patent Office**

**Office européen des brevets**

(11) Numéro de publication: **0 244 304**
**B1**

(12) **FASCICULE DE BREVET EUROPEEN**

(45) Date de publication du fascicule du brevet:
03.10.90

(51) Int. Cl.⁵: **H01L 21/306, H01L 21/28**

(21) Numéro de dépôt: 87400931.9

(22) Date de dépôt: 22.04.87

(54) **Procédé de gravure sèche sélective de couches de matériaux semiconducteurs III-V, et transistor obtenu par ce procédé.**

(30) Priorité: **30.04.86 FR 8606329**

(43) Date de publication de la demande:
**04.11.87 Bulletin 87/45**

(45) Mention de la délivrance du brevet:
**03.10.90 Bulletin 90/40**

(84) Etats contractants désignés:
**DE GB NL SE**

(56) Documents cités:
JAPANESE JOURNAL OF APPLIED PHYSICS,
vol. 20, no. 11, novembre 1981, pages L847-L850, Tokyo,
JP; K. HIKOSAKA et al.: "Selective dry etching of
AlGaAs-GaAs heterojunction"
EXTENDED ABSTRACTS,
vol. 84, no. 2, 1984, pages 504-505, no. 359, New Orleans,
Louisiana, US; J. CHAPLART et al.: "Control of the gate
recess in GaAs FET's and AlGaAs/GaAs TEGFET's
process using reactive ion etching"
APPLIED PHYSICS LETTERS,
vol. 38, no. 8, avril 1981, pages 620-622, American
Institute of Physics, New York, US; R.E. KLINGER et al.:
"Reactive ion etching of GaAs in CCl2F2"

(73) Titulaire: **THOMSON-CSF, 51, Esplanade du Général de
Gaulle, F-92800 Puteaux(FR)**

(72) Inventeur: **Vatus, Jean, THOMSON-CSF SCPI 19, avenue
de Messine, F-75008 Paris(FR)**
Inventeur: **Chevrier, Jean, THOMSON-CSF
SCPI 19, avenue de Messine, F-75008 Paris(FR)**

(74) Mandataire: **Taboureau, James et al, THOMSON-CSF
SCPI, F-92045 Paris La Défense Cédex 67(FR)**

## Description

La présente invention concerne un procédé de gravure sèche sélective d'un premier composé semiconducteur, ne comportant pas de molécule d'aluminium, sans attaque d'un second composé semi-conducteur comportant dans sa formule une molécule d'aluminium. Ce procédé est appliqué au creusement de la dépression dans laquelle est déposée la métallisation de grille d'un transistor de type à effet de champ, réalisé en matériaux du groupe III–V, dont l'un comporte de l'aluminium dans sa formule. L'invention concerne également le transistor réalisé selon ce procédé.

On sait que les résistances d'accès ou de contact entre les électrodes – source, drain et grille – d'un transistor et la couche active de ce transistor jouent un rôle important dans la détermination des caractéristiques électriques du transistor. C'est pourquoi les métallisations de source et drain sont déposées sur une couche de matériau bon conducteur. Mais cette couche doit être creusée, entre source et drain, pour que la métallisation de grille soit au plus près de la couche active du transistor: il y a donc formation d'une dépression, généralement connue sous le nom de "recess", entre source et drain. La gravure du recess peut se faire selon des méthodes humides ou sèches, mais elle doit s'arrêter à la couche active.

Un procédé connu consiste à opérer une gravure sèche par un plasma de CCl$_2$F$_2$. K. Hikosaka et al. décrivent leur méthode dans Japanese Journal of Applied Physics, vol. 20, no. 11, novembre 1981, pages L 847 à L 850. Ils opèrent avec un mélange d'hélium et de CCl$_2$F$_2$, sous une tension de polarisation pouvant atteindre 200 V et une densité de puissance aussi faible que 0,18 ou 0,35 W/cm$^2$, en une seule opération. Ces conditions ne permettent pas d'avoir, dans le fond du recess, une séparation entre la métallisation de grille et les caissons de prises de contacts de la source et du drain, parce qu'ils n'y a pas de sous-gravure.

L'invention concerne donc un procédé de gravure ionique réactive, sèche, qui est anisotrope et hautement sélective entre deux matériaux déposés sur un support et empilés, dont l'un, celui qui est en contact avec le support, comporte de l'aluminium dans une gamme de 10 à 40%, tandis que l'autre matériau, celui qui est en surface de l'empilement, ne comporte pas d'aluminium. Pour être plus clair, l'invention sera exposée en s'appuyant sur l'exemple d'un transistor dont la couche active est en AlGaAs - Al$_x$Ga$_{1-x}$As plus exactement- et la couche de prise de contact source et drain en GaAs, bien que l'invention concerne de façon plus générale les couples de matériaux du groupe III-V dont l'un seulement comprend de l'aluminium. Selon l'invention, la couche de GaAs est gravée sélectivement par gravure ionique réactive au moyen d'un plasma de fréon pur de formule C Cl$_2$ F$_2$. Dans le plasma formé, les ions chlore donnent avec le gallium, provenant de GaAs, un composé de type GaCl$_y$ volatil vers 100° C, tandis que les ions fluor donnent avec l'aluminium, provenant de AlGaAs, un composé de type AlF$_z$, qui n'est pas volatil avant 1300° C environ, et qui reste donc en surface de la couche de AlGaAs, la protégeant de l'attaque, à la température de gravure, qui doit être inférieure à 130° C environ pour être compatible avec les résines de masquage. Les conditions de pression du plasma permettent de controler l'anisotropie de la gravure, et en particulier d'opérer une sous-gravure de la couche de GaAs, sous la couche de résine qui la protège.

De façon plus précise, l'invention concerne un procédé de gravure sèche de couches de matériaux semiconducteurs du groupe III-V, la gravure étant sélective entre une première couche, contenant du gallium et partiellement protégée par un masque de résine, et une deuxième couche, contenant de l'aluminium dans une proportion de 10 à 40 %, la première couche seule devant être gravée par ce procédé qui est caractérisé en ce qu'il opère par gravure ionique réactive au moyen d'un plasma de fréon pur C Cl$_2$ F$_2$ en deux étapes :

- dans une première étape de gravure anisotrope, la première couche est gravée jusqu'à l'interface avec la deuxième couche, le plasma de fréon pur étant à une pression comprise entre 0,5 et 2,5 Pascal, sous un débit de 2 cm$^3$/min et sous une tension de polarisation de cathode de l'appareil de gravure ionique réactive comprise entre -50 et -130 V, sous une puissance de 1W/cm$^2$,

- dans une deuxième étape de gravure isotrope, la première couche est sous-gravée, sous le masque de résine, par augmentation de la pression du plasma de fréon pur, comprise entre 6 et 10 Pascal, sous un débit de 2cm$^3$/min, les conditions électriques étant les mêmes qu'en première étape.

L'invention sera mieux comprise par la description détaillée qui va être faite maintenant du procédé de gravure ionique réactive, appliqué à la réalisation d'un transistor à effet de champ, cette description s'appuyant sur les figures jointes en annexe, qui toutes se réfèrent à l'invention :

- Figure 1 : vue en coupe de la région de surface, très simplifiée, d'un transistor, dans laquelle doit être gravée sélectivement une couche de GaAs,
- Figure 2 : courbe donnant la vitesse d'érosion de GaAs et AlGaAs en fonction de la pression de plasma,
- Figure 3 : courbe donnant les concentrations en CF3 et Cl dans le plasma en fonction de la pression de plasma,
- Figure 4 : vue en coupe de la région de surface d'un transistor, après l'étape de sous-gravure de la couche superficielle de GaAs,
- Figure 5 : vue en coupe de la région de grille d'un transistor, dont le recess à été gravé par le procédé de l'invention.

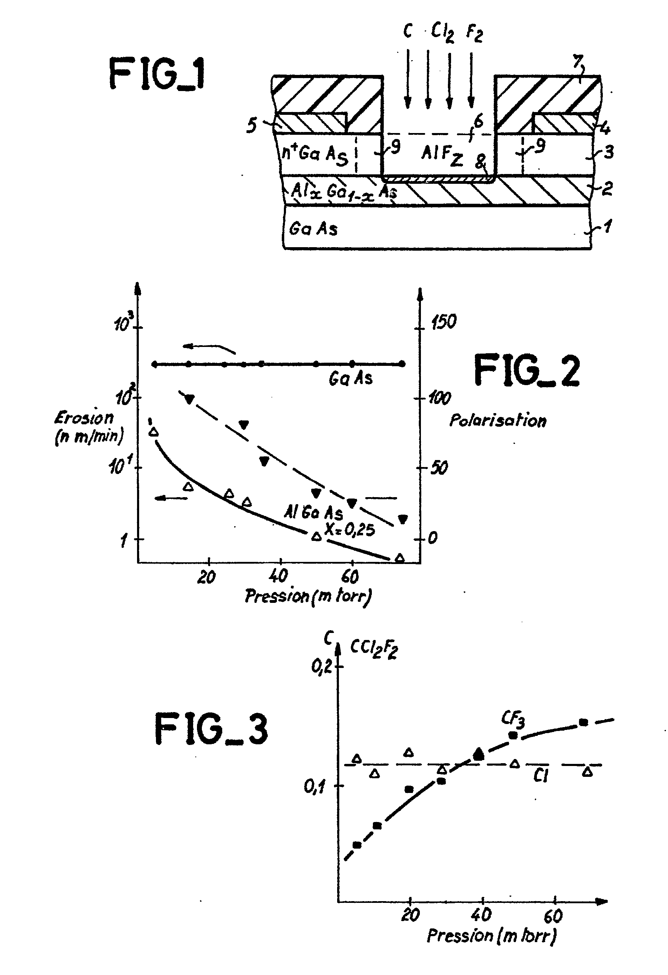

La figure 1 représente une vue en coupe, très simplifiée, de la région de surface d'un transistor à hétérojonction GaAs/AlGaAs. Sur cette figure, le transistor n'a pas encore reçu sa métallisation de grille. Cette figure permettra à la fois d'exposer le problème à résoudre et le procédé de l'invention.

Un transistor à hétérojonction comporte un support 1, dans le détail duquel il n'est pas nécessaire d'entrer, parce que les différentes couches qui composent ce support, telles que le substrat en GaAs semi-isolant, et une ou plusieurs couches de matériaux de lissage par exemple, sortent du domaine intéressant pour l'invention. Ce transistor comporte de plus au moins une couche active 2, en un matériau tel que $Al_xGa_{1-x}As$, qui est en surface du transistor, c'est-à-dire que c'est elle qui recevra la métallisation de grille. Enfin, les contacts de source et de drain sont assurés à travers une couche 3 de GaAs fortement dopé de type $n^+$, de façon à diminuer les résistances de source et de drain $R_S$ et $R_D$, entre les métallisations respectives 4 et 5 et la couche active 2. Le procédé de réalisation de la couche 3, quelqu'il soit, fournit une couche unie, et il convient donc de creuser un sillon 6, dit recess, dans la couche 3, de façon à, d'une part, séparer la couche très conductrice 3 de $n^+$GaAs en deux îlots sans contact électrique direct entre eux, et d'autre part à rapprocher la métallisation de grille de la couche active, ou, selon le type de transistor réalisé, à contrôler l'épaisseur de matériau sous la métallisation de grille de façon à contrôler la tension de seuil.

Pour obtenir ce résultat, il est connu de déposer sur la couche 3 de $n^+$GaAs deux métallisations 4 et 5 de source et de drain, puis une couche 7 de résine photo ou électrosensible, et d'ouvrir une fenêtre dans la couche de résine 7, de façon à pouvoir opérer le creusement du recess 6 par une méthode appropriée.

Après creusement du recess 6, le masque de résine 7 sert également pour le dépôt de la métallisation de grille, qui n'est pas représentée sur la figure 1, par auto-alignement sur les bords du masque.

Le procédé selon l'invention concerne précisément une méthode de gravure ionique réactive, qui permet de creuser un recess 6 dans une couche superficielle d'un matériau comportant en particulier du gallium, sans attaquer et sans détériorer la surface d'une couche sous-jacente d'un matériau comportant en particulier de l'aluminium, en quantité comprise entre 10 et 40 %, l'aluminium présent dans un matériau sous forme d'impureté n'intervenant pas dans le procédé.

Selon ce procédé, le creusement du recess 6 est obtenu au moyen d'un plasma dans du fréon pur de formule $C Cl_2 F_2$. La rondelle sur laquelle est fabriqué de façon collective le transistor, dans lequel doit être gravé le recess, est introduite dans un appareil de gravure ionique réactive, entre deux électrodes, qui sont polarisées entre -30 et -250 V à la cathode qui supporte la rondelle semiconductrice. Le plasma de $C Cl_2 F_2$ est à haute fréquence, à 13,56 Mhz. La température dans l'appareil est maintenue inférieure à 130°C, et en tout cas compatible avec la nature du masque 7, selon qu'il est en résine ou en matériaux minéraux tel que silice ou nitrure de silicium.

Dans une gravure ionique réactive, il y a un double effet : d'une part une gravure physique par les ions qui percutent la surface de la couche à graver, et d'autre part une gravure chimique. Dans un plasma de fréon pur, la molécule $C Cl_2 F_2$ se casse en un grand nombre d'ions de natures très variables, et en particulier les ions de chlore qui attaquent chimiquement la couche 3 de GaAs donnent un chlorure de gallium de forme $GaCl_x$ qui est volatil aux environs de 100° C, c'est-à-dire volatil dans les conditions de température du procédé. L'analyse chimique des ions et molécules produits au cours de la réaction, menée par spectrométrie de masse et spectrométrie d'emission optique, a permis de constater que le chlorure de gallium et l'arsénic sont tous deux présents sous forme gazeuse et que par conséquent la couche 3 de $n^+$GaAs est supprimée à la fin de l'attaque par gravure ionique réactive.

Au contraire, les ions de fluor produits dans le plasma par cassure de la molécule de fréon, lorsqu'ils arrivent en contact avec la couche 2 de GaAlAs, fournissent un fluorure d'aluminium de formule générale $AlF_z$, qui n'est volatil qu'aux environs de 1300° C. Par conséquent la couche de fluorure d'aluminium 8 formée en surface de la couche active 2 AlGaAs est solide, stable, et sur une épaisseur de quelques couches atomiques elle protège AlGaAs et inhibe la poursuite de l'attaque.

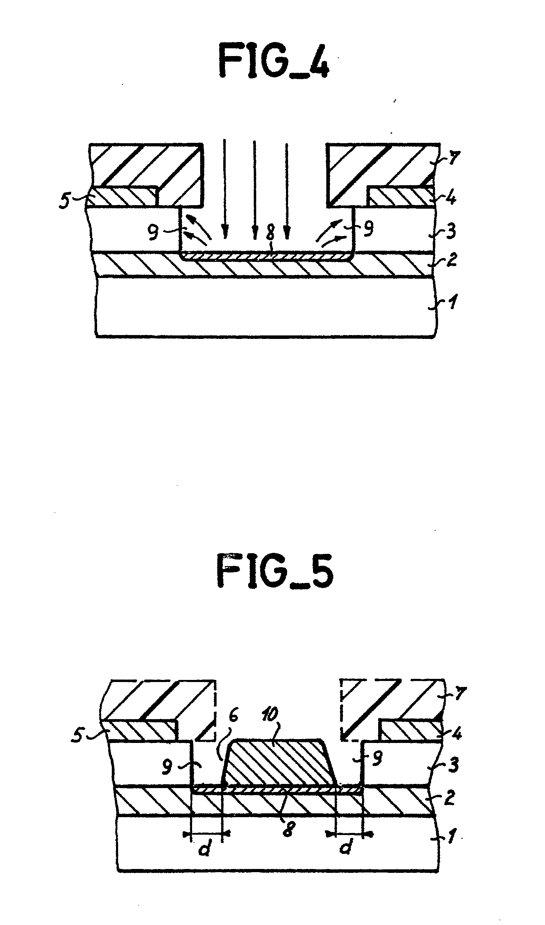

Deux traits en pointillés déterminent sur la figure 1 des espaces de sous-gravure 9 de la couche 3 de GaAs : cette sous gravure en 9 sera expliquée à l'occasion de la figure 4. Elle correspond à une seconde phase dans le procédé de gravure ionique réactive de l'invention.

Pour le couple de matériau $GaAs/Al_xGa_{1-x}As$, avec x égal à environ 0,25, c'est-à-dire $Al_{0,25}Ga_{0,75}As$ dans lequel Al est à la concentration de 20,5 %, le procédé selon l'invention donne un rapport de sélectivité de gravure supérieur à 1000, et la gravure est propre et anisotrope. Ce résultat peut être obtenu par ajustement de la pression du gaz qui produit le plasma.

Ceci est mis en évidence par les figures 2 et 3. La figure 2 donne la vitesse d'érosion, en nm par minute, pour GaAs et pour AlGaAs, en fonction de la pression, exprimée en abscisse et en millitorr, sachant que 1 torr= 1,33 $10^2$ pascal. Dans une gamme comprise entre 10 et 80 millitorr environ, c'est-à-dire 1,3 à 10,4 pascal, et avec un débit constant de fréon $C Cl_2 F_2$ pur, le taux d'érosion de GaAs ne varie pas, tandis que le taux d'érosion de AlGaAs décroît rapidement avec l'augmentation de la pression de gaz. Cet effet est en relation avec le rapport de $Cl/CF_3$ dans le plasma, qui décroit lorsque la pression de gaz augmente, ainsi que le montre la figure 3, sur laquelle la pression est portée en abscisse et la concentration des ions Cl et $CF_3$ est portée en ordonnée. L'accroissement de la concentration en $CF_3$ et le taux d'érosion vraiment faible pour AlGaAs dans un plasma de $C CL_2 F_2$ est en relation avec la formation du composé non volatil $AlF_z$, dont le plus courant et $Al F_3$ qui a une température élevée de sublimation.

Ainsi pour controler l'attaque d'une couche de GaAs par un plasma de fréon pur $C CL_2 F_2$, on peut:
- augmenter la pression de gaz, et la faire passer de 0,5 à 10 pascal environ,

- diminuer le débit de fréon introduit dans l'appareil de gravure ionique réactive, de façon à augmenter le temps de résidence d'un ion dans le plasma. Le débit utilisé varie de 20cm³/min à 0,5cm³/min, mesuré dans les conditions standard, entre le début et la fin de la gravure ionique, ou plus exactement entre la première phase et la deuxième phase de gravure ionique,
- augmenter la puissance électrique appliquée sur les deux plaques de polarisation dans l'appareil de gravure ionique, mais pas trop pour ne pas augmenter le bombardement physique du substrat par des ions. C'est pourquoi, selon le procédé, la polarisation de la cathode est maintenue entre -30 et -130 V environ ainsi qu'en témoigne la courbe en pointillée rapportée sur la figure 2,
- jouer sur le volume du plasma ou la distance interélectrode.

En fait la tension de polarisation et la distance interélectrode sont choisies de telle façon qu'elles favorisent la gravure chimique plutôt que la gravure physique par bombardement d'ions.

Les ions formés dans le plasma de fréon pur sont accélerés perpendiculairement au plan de l'anode et de la cathode dans l'appareil de gravure ionique réactive. Par conséquent ils fournissent des faisceaux d'ions parallèles entre eux et une gravure parfaitement anisotrope, telle que représenté en figure 1 : les flancs de la couche 3 de GaAs gravés sont parfaitement perpendiculaires par rapport au plan principal de ces couches.Ceci est valable dans une gamme de pression de l'ordre de 10 à 20 millitorr, c'est-à-dire de 1,3 à 2,6 pascal. Pour des pressions de fréon pur plus importantes, telles que 50 millitorr, ou 6,5 pascal, la sélectivité entre les deux matériaux devient plus importante, et une sous gravure de la couche superficielle de GaAs, sous le masque 7, peut être observée. En d'autres termes, la gravure devient moins anisotrope lorsque la pression augmente, par suite du rebondissement des ions sur la surface libre de AlGaAs, qui les fait attaquer latéralement la couche de GaAs. Cet effet peut être appliqué à la définition du recess de grille dans la fabrication d'un transistor, et à l'isolation de la métallisation de grille par rapport à la couche 3 de prise de contact en n+GaAs.

C'est ce que représente la figure 4, qui correspond à la seconde étape du procédé, étape au cours de laquelle la pression a été augmentée passant de 0,5 à 10 pascal environ, tandis que le débit de gaz peut être diminué de 2 à 0,5cm³/min.

La figure 5 représente la région superficielle d'un transistor fabriqué en utilisant le procédé de l'invention pour creuser le recess de la métallisation de grille. Sur cette figure on a conservé en pointillé le masque 7 de résine, le même que celui qui a servi en figure 1 et 4 aux deux opérations de gravure ionique, ce masque servant à l'autoalignement de la métallisation de grille 10 par évaporation de métal. Du fait que la couche de prise de contact 3 a été gravée sous la couche de résine 7, il existe entre les bords de la métallisation 10 et les bords des couches de contact 3 une légère distance "d", qui évite un court-circuit entre la métallisation de grille 10 et les couches conductrices 3. Cette distance "d" peut être contrôlée par plusieurs paramètres tels que la pression de gaz au cours de la gravure ionique réactive, la durée de l'opération.

Bien entendu au cours du dépôt de la métallisation de grille 10, le métal évaporé est également déposé sur le masque 7, bien que cette couche ne soit pas représentée sur la figure 5. A l'issue de cette opération de métallisation, le masque 7 et la couche de métal qu'il supporte sont ôtés par une opération de dissolution de la résine, opération connue sous le nom de lift-off, et le transistor à effet de champ est achevé.

Il est caractérisé par une fine couche 8 de fluorure d'aluminium qui se trouve en surface de sa couche active 2, et en contact avec la métallisation de grille 10. Cette fine couche de fluorure d'aluminium a une épaisseur de quelques couches atomiques, et elle se comporte du point de vue électrique avec des caractéristiques proches des caractéristiques d'un contact Schottky.

Le procédé selon l'invention est applicable au moyen d'une machine de gravure ionique réactive conventionnelle et disponible dans le commerce.Cette machine est d'abord nettoyée en opérant un vide de $10^{-6}$ torr dans la chambre, avant l'introduction de fréon pur. Il est nécessaire qu'elle dispose d'une puissance de l'ordre de 0,8 W/cm² pour mener à bien la gravure ionique réactive selon l'invention, et de moyens permettant de controler le débit de fréon pur $C\,Cl_2\,F_2$, dans une gamme de l'ordre de 2 cm³/min. Sur cette machine de gravure ionique réactive sont branchés d'une part un spectromètre de masse pour analyser les espèces fournies par le plasma, et un monochromateur opérant dans la gamme de 200 à 600 nanomètres, ces deux moyens étant utilisés en parallèle pour l'identification des espèces fournies.

L'invention a été exposée en s'appuyant sur le cas de la fabrication d'un transistor à effet champ comportant en surface une couche de GaAs et, sous-jacente, une couche de AlGaAs. Bien entendu l'invention s'applique à d'autres produits que les transistors, tels que les diodes électroluminescentes ou les lasers, et à d'autres produits que le couple cité. De façon plus générale il est nécessaire que la couche en surface comporte un atome tel que le gallium donnant avec le chlore un composé volatil, et que la couche sous jacente comporte dans sa formule un atome d'aluminium donnant avec le fluor un composé non volatil à la température où est menée la gravure ionique réactive. De façon plus générale par conséquent le procédé permet une gravure sélective entre les composés ternaires ou quaternaires du groupe III-V, à condition que l'un des deux composés, celui qui doit ne pas être attaqué, comporte de l'aluminium.

**Revendications**

1. Procédé de gravure sèche de couches de matériaux semi-conducteurs du groupe III-V, la gravure étant sélective entre une première couche (3), contenant du gallium et partiellement protégée par une masque de résine (7), et une deuxième couche (2), contenant de l'aluminium dans une proportion de 10 à 40%, la première couche (3) seule devant être gravée par ce procédé qui est caractérisé en ce qu'il opère par gravure ionique réactive au moyen d'un plasma de fréon pur C Cl₂F₂ en deux étapes:

— dans une première étape de gravure anisotrope, la première couche (3) est gravée jusqu'à l'interface avec la deuxième couche (2), le plasma de fréon pur étant à une pression comprise entre 0,5 et 2,5 Pascal, sous un débit de 2 cm³/min et sous une tension de polarisation de cathode de l'appareil de gravure ionique réactive comprise entre −50 et −130 V, sous une puissance de 1 W/cm²,

— dans une deuxième étape de gravure isotrope, la première couche (3) est sous-gravée, sous le masque de résine (7), par augmentation de la pression du plasma de fréon pur, comprise entre 6 et 10 Pascal, sous un débit de 2 cm³/min, les conditions électriques étant les mêmes qu'en première étape.

2. Procédé de gravure sèche sélective selon la revendication 1, caractérisé en ce que la première couche (3) est en GaAs ou en un alliage du groupe III–V comprenant du gallium, et en ce que la deuxième couche (2) est en Al$_x$Ga$_{1-x}$As(x ≈ 0,25) ou en un alliage de groupe III–V comprenant de l'aluminium.

3. Procédé de gravure sèche sélective selon la revendication 1, caractérisé en ce que la gravure de la deuxième couche (2) est arrêtée par la formation d'une couche superficielle (8) de AlF$_z$ sur une épaisseur de quelques couches atomiques.

4. Procédé de gravure sèche sélective selon l'une quelconque des revendications 1 ou 3, caractérisé en ce que la deuxième étape de gravure permet de régler la distance (d) qui sépare les bords d'une métallisation de grille (10), autolignée, des bords des couches de contact (3) des métallisations de source et de drain (4, 5), et en ce que la couche résiduelle (8) de AlF$_z$, en surface de la deuxième couche (2), constitue un contact Schottky.

## Claims

1. A method for the dry etching of layers of group III–V semiconductor materials, the etching being selective between a first layer (3) containing gallium and partially protected by a resin mask (7), and a second layer (2), containing 10 to 40% of aluminum, the first layer (3) alone having to be etched by said method, which is characterized in that it functions by reactive ion etching using a plasma of pure freon C Cl₂F₂ in two stages:

— in a first stage of anisotropic etching, the first layer (3) is etched away as far as the interface with the second layer (2), the pure freon plasma being under a pressure comprised between 0.5 and 2.5 Pascal at a feed rate of 2 cc/min and under a polarizing voltage of the cathode of the reactive ionic etching device comprised between −50 and −130 V, with a power of 1 W/cm²,

— in a second isotropic etching stage the first layer (3) is under-etched, under the resin mask (7), by the increase in the pressure of the pure freon plasma, comprised between 6 and 10 Pascal, at a feed rate of 2 cc/min., the electrical conditions being the same as in the first stage.

2. The selective dry etching method as claimed in claim 1, characterized in that the first layer (3) is a layer of GaAs or an alloy of the III–V group comprising gallium, and in that the second layer (2) is a layer of Al$_x$Ga$_{1-x}$As (x ≈ 0.25) or of an alloy of the III–V group comprising aluminum.

3. The selective dry etching method as claimed in claim 1, characterized in that the etching of the second layer (2) is halted by the formation of a superficial layer (8) of AlF$_z$ with a thickness of a few atomic layers.

4. The selective dry etching method as claimed in any one of the preceding claims 1 through 3, characterized in that the second etching stage makes it possible to regulate the distance (d) which separates the edges of a selfaligned gate metallization layer (10), from the edges of the contact layers (3) of source and drain metallization layers (4 and 5) and in that the residual layer (8) of the AlF$_z$, at the surface of the second layer (2), constitutes a Schottky contact.

## Patentansprüche

1. Verfahren zum Trockenätzen von Schichten aus einem Halbleitermaterial der Gruppen III-V, wobei die Ätzung zwischen einer ersten Schicht (3), die Gallium enthält und teilweise durch eine Harzmaske (7) geschützt ist, und einer zweiten Schicht (2), die Aluminium in einem Verhältnis zwischen 10 und 40 % enthält, selektiert, und wobei nur die erste Schicht (3) durch dieses Verfahren geätzt werden darf, dadurch gekennzeichnet, daß es durch eine reaktive Ionenätzung mittels eines Plasmas aus reinem Freon C Cl₂ F₂ in zwei Schritten ausgeführt wird:

- in einem ersten Schritt einer anisotropen Ätzung, in dem die erste Schicht (3) bis zur Grenzfläche der zweiten Schicht (2) geätzt wird, wobei das Plasma aus reinem Freon unter einem Druck zwischen 0,5 und 2,5 Pascal steht, bei einer Dosis von 2 cm³/min, einer Polarisationsspannung der Katode des Gerätes zur reaktiven Ionenätzung zwischen -50 und -130 V und bei einer Leistung vom 1 W/cm²,

- in einem zweiten Schritt einer isopropen Ätzung, in dem die erste Schicht (3) durch eine Erhöhung des Druckes des Plasmas aus reinem Freon auf 6 bis 10 Pascal unter der Harzmaske (7) geätzt wird, bei einer Dosis von 2 cm³/min, wobei die elektrischen Bedingungen die gleichen sind wie im ersten Schritt.

2. Verfahren zum selektiven Trockenätzen gemäß Anspruch 1, dadurch gekennzeichnet, daß die erste Schicht (3) aus GaAs oder aus einer Gallium enthaltenden Legierung der Gruppen III-V besteht und daß die zweite Schicht (2) aus Al$_x$Ga$_{1-x}$As (x ≈ 0,25) oder aus einer Aluminium enthaltenden Legierung der Gruppen III-V besteht.

3. Verfahren zum selektiven Trockenätzen gemäß Anspruch 1, dadurch gekennzeichnet, daß die Ätzung der zweiten Schicht (2) durch die Ausbildung einer künstlichen Schicht (8) aus AlFz mit einer Dicke von einigen Atomlagen angehalten wird.

4. Verfahren zum selektiven Trockenätzen gemäß einem der Ansprüche 1 oder 3, dadurch gekennzeichnet, daß der zweite Schritt des Ätzens die Einstellung des Abstandes (d) erlaubt, der die Kanten einer sich selbst ausrichtenden Gatemetallisierung von den Kanten der Kontaktschichten (3) der Source- und der Drainmetallisierungen (4, 5) trennt, und daß die verbleibende Schicht (8) aus AlFz auf der Oberfläche der zweiten Schicht (2) einen Schottky-Kontakt ausbildet.

EP 0 244 304 B1

FIG_1

FIG_2

FIG_3

# FIG_4

# FIG_5